# EUROPEAN PATENT SPECIFICATION

(11) **EP 0 858 472 B1**
(45) Date of publication and mention of the grant of the patent: **20.06.2001**
(21) Application number: 96935493.5
(22) Date of filing: 30.10.1996
(51) Int. Cl.: C08G 59/42, G03F 7/032, C08F 290/06

(54) **PHOTOSENSITIVE RESIN COMPOSITION**
PHOTOEMPFINDLICHE HARZZUSAMMENSETZUNG
COMPOSITION DE RESINE PHOTOSENSIBLE

(30) Priority: 30.10.1995 JP 28210695
(43) Date of publication of application: 19.08.1998
(73) Proprietor: National Starch and Chemical Investment Holding Corporation, Wilmington, Delaware 19809 (US)
(72) Inventor: NISHIKAWA, Katsue, Kanagawa-ken 243 (JP); KINASHI, Keiichi, Kanagawa-ken 243-04 (JP); CHIBA, Reiko, Kanagawa-ken 243-02 (JP); HAGIWARA, Youshichi, Kanagawa-ken 243-02 (JP)
(74) Representative: Held, Stephan, Dr.rer.nat., Dipl.-Chem.
(86) International application number: JP9603173
(87) International publication number: WO9716470

(56) References cited:
- US-A- 4 948 700
- US-A- 5 281 678

## Description

### TECHNICAL FIELD

The present invention relates to a photosensitive resin composition which is used in the step of producing printed circuit boards. More particularly, it relates to a photosensitive resin composition which acts as a protective coating at soldering and plating and is also useful as a permanent protective coating when the printed circuit board is used.

### BACKGROUND ART

Various resist materials are used for forming resist patterns in the step of producing printed circuit boards. Of these resist materials, the one that is called as solder resist is used as the protective coating in soldering or plating a printed circuit board or as the permanent protective coating in using the printed circuit board. Heretofore, in the pattern formation of this solder resist the method of screen-printing a resist material has been employed but with the recent miniaturization and high densification of electronic parts and circuits, the demand for high densification of resist patterns has been increased and the patterning is being conducted by the photographic method.

In forming resist patterns by the photographic method, the developing step is essential, and recently the developing step conducted by using an organic solvent is being replaced by that using water, particularly an aqueous alkali solution from the standpoints of environmental problems and workers' health problems. As seen in Japanese Patent Publication (Kokoku) No. Hei 1-54390/1989 and Japanese Patent Publication (Kokai) No. Hei 2-173747/1990, the introduction of carboxyl groups into one component of the resist composition is carried out for making the development with an alkali aqueous solution possible.

These resin compositions are substantially watersoluble and thus, in order to improve the performances of a coating, an epoxy resin is added to a compound having a carboxyl group to conduct heat curing by causing a crosslinking reaction. However, since the epoxy resin is insoluble in water and an aqueous alkali solution, a particulate epoxy resin which is difficultly soluble in a solvent is added as described in Japanese Patent Publication (Kokai) No. Hei 7-17737/1995 in order to improve the developability of the epoxy resin with water. According to this method, the epoxy resin does not dissolve in the composition and is present in the form of powder (or particles). Accordingly, the epoxy resin is not developed by dissolving in water but it is developed by breaking up in pieces by water and being washed off. The type of difficultly soluble epoxy resin which can be employed in such a method is limited and it is difficult to uniformly disperse a difficultly soluble epoxy resin into the composition and there is a problem that a special technique for dispersion is required.

Also, surface mounting has recently been widely carried out and thus, gold plating of terminals and bonding pads has often been conducted by electroless gold plating and thus, the resist coating is often susceptible to damage in this electroless gold plating.

### DISCLOSURE OF INVENTION

The present invention is directed to a modified epoxy resin having a unit (A) represented by the formula (A), 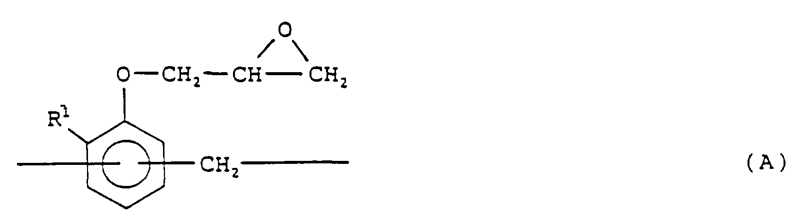 a unit (B) represented by the formula (B), 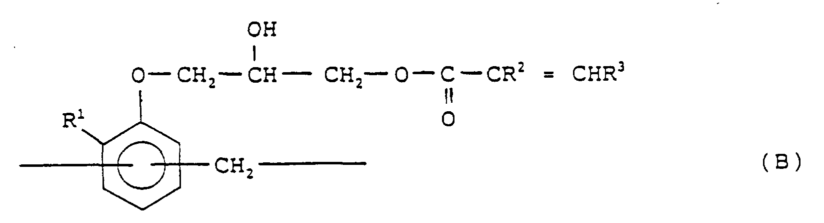 and a unit (C) represented by the formula (C), 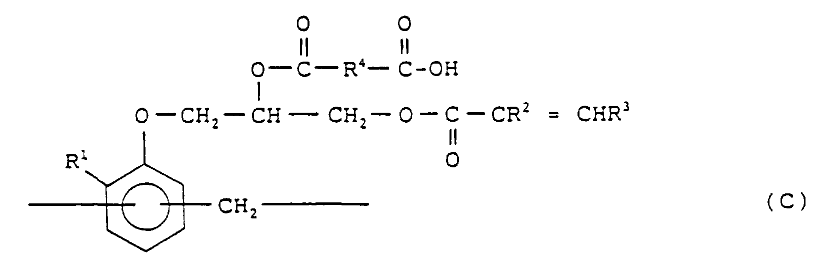 wherein
R¹ is a hydrogen or a methyl group;
R² is a hydrogen or a methyl group;
R³ is a hydrogen, a methyl group or a phenyl group; and
R⁴ is a residue of an aliphatic or aromatic polycarboxylic acid anhydride,
at a mol ratio of the epoxy group : the unsaturated group : the carboxyl group in the molecule being 30-70 : 30-70 : 10-70 and the modified epoxy resin product being obtainable by reacting a novolak epoxy resin having a softening point of not lower than 60°C with an unsaturated monocarboxylic acid represented by the formula, 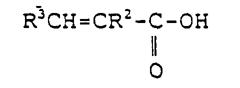 wherein
R² and R³ are the same as defined above, in an amount of 30 to 70% by mol per equivalent of the epoxy group in the starting novolak epoxy resin in the presence of a trivalent organic phosphorus compound as the catalyst in a diluent; deactivating the catalytic action of the trivalent organic phosphorus compound; and subsequently reacting the resulting reaction product with a polycarboxylic acid anhydride represented by the formula, 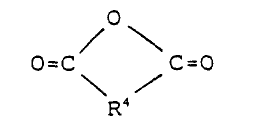 wherein
R⁴ is the same as defined above, in an amount of 10 to 70% by mol per equivalent of the epoxy group present in the starting novolak epoxy resin.

The present invention is also directed to a photosensitive resin composition which comprises:
(a) 40 to 70% by weight of a solution of the above described modified epoxy resin product having a solids content of 25 to 91% by weight;
(b) 1 to 10% by weight of an unsaturated compound having at least three unsaturated groups in the molecule;
(c) 0.1 to 2% by weight of an epoxy resin curing agent;
(d) 2 to 15% by weight of a photopolymerization initiator; and
(e) 10 to 50% by weight of an inorganic filler.

### DETAILED DESCRIPTION OF THE INVENTION

In accordance with the invention, the present inventors have discovered that by using the novel modified epoxy resin product having curable epoxy groups and aqueous alkali solution-soluble carboxyl groups in the resin molecule as the base resin for a photosensitive resin composition, the photosensitive resin composition becomes a solder resist which has excellent developability and sufficient durability in the soldering step and the plating step and can be formed into patterns by the photographic method.

As to the epoxy resin which is generally used for the preparation of the modified epoxy resin product of the present invention as the base resin for a photosensitive resin composition, it is important to employ a novolak epoxy resin having a softening point of not lower than 60°C and a unit represented by formula (A), 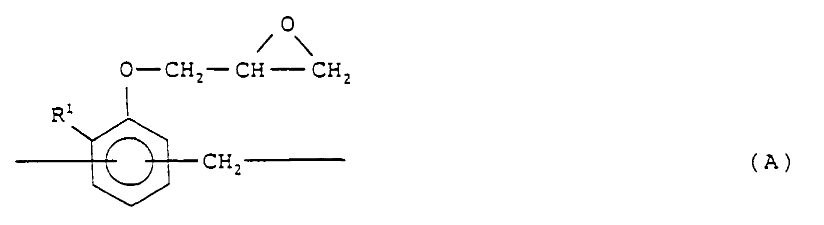 wherein R¹ is a hydrogen or a methyl group, especially from the standpoints of photosensitivity, developability, properties of the cured products, ease of handling in the patterning process and particularly, less tackiness at the time of exposure after drying.

Exemplary novolak epoxy resins include phenol novolak epoxy resins such as EPPM®-201 (a product of Nippon Kayaku Co., Ltd.) and cresol novolak epoxy resins such as ESCN®-195 XL Series (o-cresol novolak epoxy resins, products of Sumitomo Chemical Co., Ltd.) and YDCN®-701, 702, 703 and 704 (o-cresol novolak epoxy resins, products of Toto Kasei K.K.) and they may be used singly or in combination.

The unsaturated monocarboxylic acids which can be employed for the preparation of a modified epoxy resin product of the present invention are compounds having one ethylenically unsaturated bond and one carboxyl group in the molecule and represented by the formula 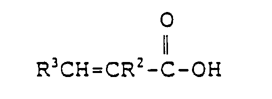 wherein
R² is a hydrogen atom or a methyl group; and
R³ is a hydrogen atom, a methyl group or a phenyl group.

Exemplary unsaturated monocarboxylic acids include acrylic acid, methacrylic acid, crotonic acid and cinnamic acid. If necessary or desired, other monocarboxylic acids may be used together for the purposes of controlling the molecular weight of the modified epoxy resin product formed, controlling the photopolymerization reactivity the modified epoxy resin product formed and improving the properties of the resins after curing such as flexibility, adhesion, heat-resistance and fire retardancy. Exemplary carboxylic acids include aliphatic monocarboxylic acids such as acetic acid, propionic acid, butyric acid, isobutyric acid, lauric acid, myristic acid, palmitic acid and stearic acid; and aromatic monocarboxylic acids such as toluic acid and naphthoic acid.

The mol ratio of the epoxy group in the novolak epoxy resin to the carboxyl group in the unsaturated monocarboxylic acid which is used in the reaction of the novolak epoxy resin with the unsaturated monocarboxylic acid for the preparation of a modified epoxy resin product of the present invention is 100:30-70. When the mol ratio is less than the lower limit, sufficient photocuring cannot be obtained and mol ratios of greater than the upper limit deteriorate the coating properties of the cured product.

In the present invention it is essential to use a trivalent phosphorus compound as the reaction catalyst in the reaction of the novolak epoxy resin with the unsaturated monocarboxylic acid for the preparation of a modified epoxy resin product.

Examples of such a trivalent phosphorus compound include alkylphosphines such as triethylphosphine, tri-n-propylphosphine and tri-n-butylphosphine; arylphosphines such as triphenylphosphine, tri-m-tolylphosphine and tris(2,6-dimethoxyphenyl)phosphine; and phosphorous triesters such as triphenyl phosphite and tris(nonyl-phenyl)phosphite. Of these trivalent phosphorus compounds, triphenylphosphine is particularly preferred because it is easy to handle at normal temperature and has low toxicity and can easily be oxidized in the next reaction step to lose its catalytic activity.

Although there is no particular restriction on the amount of the trivalent phosphorus compound which can be used in the present invention, 0.01 to 5% by weight based on the total weight of the epoxy compound and the unsaturated monocarboxylic acid is typically employed. When the amount of the trivalent phosphorus compound is less than 0.01% by weight, the rate of the esterification reaction is too slow. Also, amounts of greater than 5% by weight take a longer period of time in the deactivation reaction of the catalytic activity in the next reaction step.

The reaction between the novolak epoxy resin for the preparation of the modified epoxy resin product of the present invention and the unsaturated monocaroxylic acid is carried out under conventional conditions. More specifically, the reaction is carried out at a temperature of 50°C to 150°C, preferably 70°C to 120°C until the presence of the unsaturated monocarboxylic acid is no longer observed in the reaction product.

In this reaction a conventional thermal polymerization inhibitor such as a quinone, a phenol, a polyhydric phenol, a nitro compound and a phenothiazine is preferably employed for the purpose of preventing the polymerization of the unsaturated group in the reaction product. The amount of the thermal polymerization inhibitor which can be employed is typically 0.005 to 0.1% by weight based on the total weight of the novolak epoxy resin and the unsaturated monocarboxylic acid. When the amount of the thermal polymerization inhibitor is less than 0.005% by weight, the effect on preventing the thermal polymerization of the unsaturated group is not sufficient. Also, amounts of greater than 0.1% by weight deteriorate the photocurability of the photosensitive resin composition as prepared.

Furthermore, in order to regulate the viscosity of the preparation system of the modified epoxy resin product or the viscosity of the modified epoxy resin product formed, diluents which are usually employed as additives or solvents in this technological field can be used. Exemplary diluents include liquid unsaturated monomers such as trimethylolpropane triacrylate, pentaerythritol triacrylate and dipentaerythritol hexaacrylate; and organic solvents such as methyl ethy ketone, cyclopentanone, toluene, xylene, ethylene glycol monoethyl ether acetate, ethylene glycol monobutyl ether acetate, diethylene glycol monoethyl ether acetate and propylene glycol monomethyl ether acetate. The amount of the diluent which can be used in the present invention is typically 10 to 300 parts by weight based on 100 parts by weight of the modified epoxy resin product to be formed. In other words, the solids concentration in the solution of a modified epoxy resin product formed is 25 to 91% by weight. When the solids concentration is less than this lower limit, the viscosity of the photosensitive resin composition as finally obtained is too low for the coating step. Also, the solids concentration is higher than the upper limit, unfavorable side reactions are caused in the preparation of the modified epxoy resin product to gel the reaction product.

As described above, by the reaction between the novolak epoxy resin and the unsaturated monocarboxylic acid, 30 to 70% by mol of epoxy groups of the novolak epoxy resin are reacted with the unsaturated monocarboxylic acid, i.e., 30 to 70% by mol of the unit represented by the formula (A) as described above are converted into a unit represented by the formula (B), 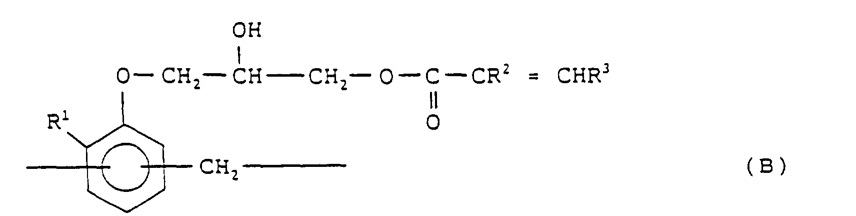 wherein
R¹ and R² each is a hydrogen or a methyl group; and
R³ is a hydrogen, a methyl group or a phenyl group or a phenyl group, to give a modified epoxy resin product and thus, an unsaturated group of -O-C(=O)-CR²=CHR³ is introduced into the novolak epoxy resin.

According to the method of the present invention, the deactivation of catalytic activity of the trivalent phosphorus compound which has been used in the above described reaction is carried out as described in Japanese Patent Publication (Kokai) No. Hei 5-320312/1993, since the remains of the trivalent phosphorus compound in the modified epoxy resin product bring about such a disadvantage that they act as the catalyst for the reaction between epoxy groups and an acid anhydride to be added in the next reaction step to cause gelation of a reaction product during the reaction or they cause a reaction between epoxy groups and carboxyl groups in the modified epoxy resin product to form a gel during the storage of the modified epoxy resin product or the photosensitive resin composition as finally obtained.

In the present invention, the deactivation of the trivalent phosphorus compound which has been used in the reaction between the novolak epoxy resin and the unsaturated monocarboxylic acid can easily be carried out by the oxidation of the trivalent phosphrous compound into a pentavalent phosphorus compound having no catalytic activity for the reaction of the carboxyl group and the epoxy group with a known oxidizing agent.

The oxidizing agents which can be used in this oxidation reaction of the trivalent phosphrous compound include, for example, epoxy compounds organic peroxides, hydrogen peroxide, trichloroacetamide, secondary and tertiary α-halogenated aldehydes, mono-α-halogenated amides, halogenated phenols, ozone, ozonides, potassium permanganate, chromic acid, sulfur and dimethyl sulfoxide. Of these oxidizing agents, preferred are organic peroxides and hydrogen peroxide because they do not damage the properties of the photosensitive resin composition as finally obtained and do not cause side reactions such as polymerization of the unsaturated bond.

In the present invention it is preferred to use a hydroperoxide which will not generate a radical capable of polymerizing the unsaturated bond as the peroxide for the oxidation of the trivalent phosphorus compound. Examples of such hydroperoxides include tert-butyl hydroperoxide, cumene hydroperoxide, diisopropylbenzene hydroperoxide, 2,5-dimethylhexane-2,5-dihydroperoxide, p-methane hydroperoxide, 1,1,3,3-tetramethylbutyl hydroperoxide and hydrogen peroxide.

The amount of these oxidizing agents which can be used is typically 0.2 to 3.0 mols per mol of the trivalent phosphorus compound employed. When the amount of the oxidizing agent is less than 0.2 mol, a sufficient oxidation/deactivation reaction of the trivalent phosphorus compound does not occur. Also, when the amount of the oxidizing agent is greater than 3.0 mols, the polymerization of the unsaturated bond tends to slowly occur. Since the trivalent phosphorus compound can be oxidized by the epoxy group and the solubilized oxygen present in the reaction mixture, the object of the present invention can sufficiently be attained even at a mol ratio of the oxidizing agent to be used to the trivalent phosphorus compound of less than 1 if it is only within the above described range.

The oxidation/deactivation reaction of the trivalent phosphorus compound with an oxidizing agent in the present invention is carried out by adding an oxidizing agent to the reaction mixture after the reaction of the novolak epoxy resin and the unsaturated monocarboxylic acid with the use of a trivalent phosphorus compound as the catalyst and heating the resulting mixture at a temperature of 50°C to 120°C. When the temperature is lower than 50°C, the reaction proceeds too slowly. On the other hand, when the temperature is higher than 120°C, the polymerization of the unsaturated bond disadvantageously occurs.

After completion of the oxidation/deactivation reaction of the trivalent phosphorus compound as described above, part of or the entire of the hydroxyl groups formed by opening the epoxy group in the reaction of the epoxy groups and the unsaturated monocarboxylic acid is reacted with a polycarboxylic acid anhydride to introduce carboxyl groups in the novolak epoxy resin, i.e., part or the entire of the hydroxyl groups formed by opening the epoxy group of the unit represented by the formula (B) is reacted with a polycarboxylic acid anhydride represented by the formula, 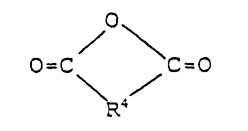 to form a unit represented by the formula (C), 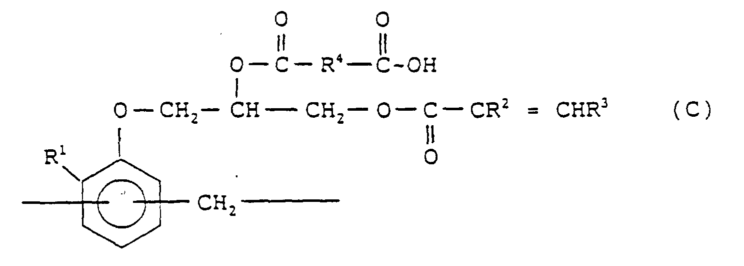 wherein
R¹, R² and R³ are the same as defined above; and
R⁴ is a residue of an aliphatic or aromatic polycarboxylic acid anhydride, and thus, a carboxyl group of -O-C(=O)-R⁴-C(=O)-OH is introduced into the novolak epoxy resin.

Exemplary polycarboxylic acid anhydrides which can be employed in the present invention include maleic anhydride, succinic anhydride, itaconic anhydride, phthalic anhydride, chlorendic anhydride, tetrahydrophthalic anhydride, methylhexahydrophthalic anhydride, hexahydrophthalic anhydride, 5-norbornene-2,3-dicarboxylic anhydride, trimellitic anhydride, pyromellitic anhydride and benzophenone tetracarboxylic anhydride. These polycarboxylic acid anhydrides may be used alone or as a mixture of two or more.

The polycarboxylic acid anhydride is reacted is in such an amount that the amount of carboxyl groups in the polycarboxylic acid anhydride becomes 10 to 70% by mol based on the epoxy groups in the starting epoxy resins. More specifically, 33 to 100% of the groups converted from the unit (A) represented by the formula (A) to the unit (B) represented by the formula (B) in the previous reaction step are converted to the unit (C) represented by the formula (C). When the amount of the polycarboxylic acid anhydride is below this range it becomes difficult to develop the photosensitive resin composition with an alkali aqueous solution. Also, when the amount is above the range, the water resistance and the electrical properties of the cured coating as finally obtained are deteriorated.

In the present invention the above described reaction for introducing carboxyl groups is carried out at a temperature ranging from room temperature to 100°C. Also in this reaction known additives such as the above described polymerization inhibitors, diluents and plasticizers can be used. By carrying out this reaction, 33 to 100% of the hydroxyl groups formed by the opening of epoxy groups in the previous reaction step react with the polycarboxylic acid anhydride, and thus, carboxyl groups are introduced into the epoxy resin molecule.

The reactions for modifying the epoxy groups in the epoxy resin by introducing unsaturated groups and carboxyl groups into the epoxy resin as explained above can be shown by the following formulae.

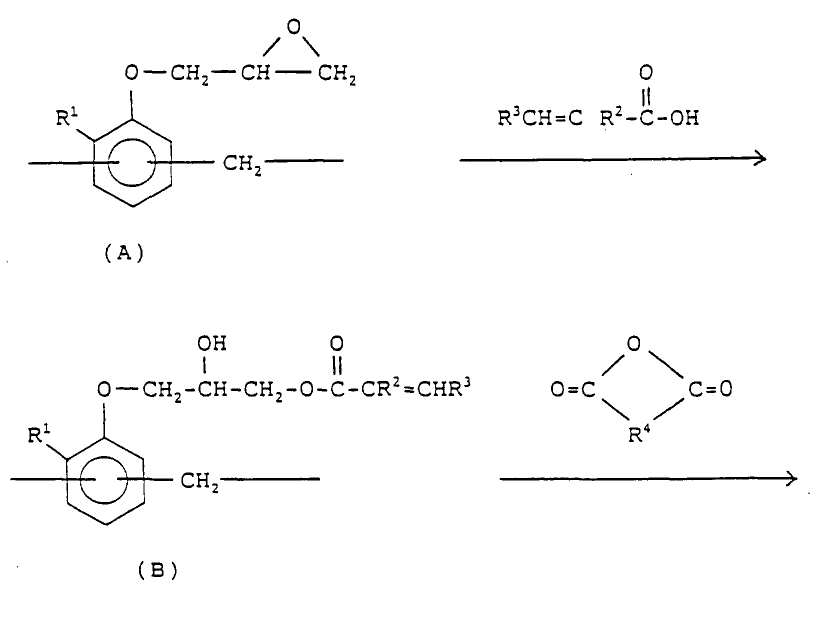

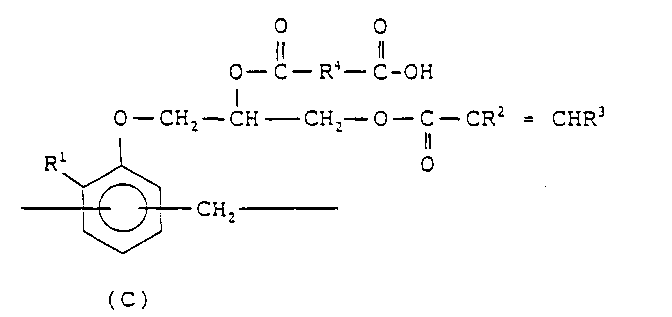

In the modified epoxy resin product as finally obtained, the unit represented by formula (A) i.e., unit (A) having an epoxy group and the unit represented by formula (C), i.e., unit (C) having an unsaturated group and a carboxyl group are present, with or without the unit represented by formula (B), i.e., unit (B) having an unsaturated group, as a mixture in the molecule. As the ratio of these units present in the molecule of the modified epoxy resin as obtained, the mol ratio of unit (A)/unit (B)/unit (C) is 30-70/0-60/10-70. Also the mol ratio of epoxy group 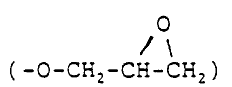 / unsaturated group [-O-C(=O)=CR²=CHR³] / carboxyl group [-O-C(=O-R⁴-C(=O)-OH] in the molecule of the modified epoxy resin product as obtained is 30-70/30-70/10-70.

The photosensitive resin composition of the present invention can be prepared by using, as the base resin, the modified epoxy resin product as obtained in the above described manner.

The amount of the above described modified epoxy resin product which is used in the photosensitive resin composition of the present invention is 40 to 70% by weight of the total photosensitive composition as the modified epoxy resin product solution containing the diluent as used in the preparation of the modified epoxy resin product. When the amount of the modified epoxy resin solution is less than 40% by weight, sufficient photosensitivity, developability with an alkaline aqueous solution and properties of a cured product as the protective coating cannot be obtained and when the amount is greater than 70% by weight, the properties of a cured product, particularly the heat resistance and the thermal shock resistance are deteriorated.

An unsaturated compound having at least three unsaturated groups in the molecule is used as the second essential component (b) of the photosensitive resin composition of the present invention. Such an unsaturated compound is added in order to improve the adjustment of the viscosity and the photosensitivity of the photosensitive resin composition and the properties of a cured product. The unsaturated compound which can be used for this purpose may be any known unsaturated compound but it is particularly preferred for improving the photosensitivity of the photosensitive resin composition and the properties of a cured product that an unsaturated compound having at least three unsaturated groups in the molecule.

Examples of such an unsaturated compound having at least three unsaturated groups in the molecule include trimethylolpropane triacrylate, pentaerythritol triacrylate, pentaerythritol pentaacrylatae, dipentaerythritol pentaacrylate, 1,3,5-triacryloyl-hexahydro-s-triazine and caprolactam adduct of dipentaerythitol hexaacrylate. Also, an unsaturated epoxy ester which is called as an epoxy acrylate obtained by reacting an epoxy resin having at least three unsaturated epoxy groups in the molecule with an unsaturated carboxylic acid or its solution can be used.

The amount of the unsaturated compound having at least three unsaturated groups in the molecule is preferably 1 to 10% by weight based on the total weight of the photosensitive resin composition. When the amount of the unsaturated compound having at least three unsaturated groups in the molecule is less than 1% by weight, sufficient sensitivity of the photosensitive resin composition cannot be obtained. Also, amounts of greater than 10% by weight may cause the lowering in flexibility of a cured product or the tackiness after drying at the time of exposure. If necessary or desired, a compound having one or two unsaturated groups in the molecule may be additionally used.

An epoxy resin curing agent is used as the third essential component (c) of the photosensitive resin composition of the present invention. For such an epoxy resin curing agent any conventional curing agents may be used and preferred are melamine compounds, dicyandiamide compounds, imidazole derivatives, urea compounds and guanamine compounds. These curing agents are, in general, insoluble or difficultly soluble in the photosensitive resin composition or the solvent employed and accordingly, the storage stability of the photosensitive composition as obtained becomes good.

Examples of the melamine compound which can be used as the epoxy resin curing agent include 2,4,6-triamino-1,3,5-triazine which is commercially available as the fine powder melamine (a product of Nissan Chemical Industries, Ltd.), CYMEL® 303, 350, 370, 701, 202 and 207 which are hexamethoxy or butylated melamines (products of Mitsui Cyanamide Co., Ltd.) and NIKALAC MW-30M and MW-22 (products of Sanwa Chemical Co., Ltd.). As the dicyandiamide compound, EPICURE DICY 7A (a product of Yuka Shell Co., Ltd.) can be mentioned. Examples of the imidazole derivative compound include 2PZ-CNS, 2PHZ-CN, 2MA-OK, 2P4MHZ and 2PHZ (products of Shikoku Kasei Co., Ltd.) and examples of the urea compound include N,N-dimethylurea, N,N-diethylurea, N-(3,4-dichlorophenyl)-1,1-dimethylurea, 1,1'-isophorone-bis(3,3-dimethylurea and 1,1'-isophorone-bis(3-methyl-3-hydroxyethylurea) and examples of the guanamine compound include acetoguanamine, benzoguanamine, 3,9-bis [2-(3,5-diamino-2,4,6-triazaphenyl)-2,4,8,10-tetraoxaspiro-(5,5)-undecane.

The amount of the epoxy resin curing agent which can be employed in the present invention is 0.1 to 2% by weight based on the total weight of the photosensitive resin composition. When the amount is less than 0.1% by weight, it is difficult to sufficiently cure the photosensitive resin composition. Also, amounts of greater than 2% by weight deteriorate the properties of the cured product or-reduce the storage stability of the photosensitive resin composition.

Exemplary photopolymerization initiators which can be employed as the fourth essential component (d) of the photosensitive resin composition of the present invention include quinones such as 2-ethylanthraquinone, 2-t-butylanthraquinone and 2-benzanthraquinone; a-ketaldonyl alcohols or ethers such as benzoin ether, pivaloin ether and acyloin ether; ethers; and ketones such as a-phenylbenzoin, a,a'-diethoxyacetophenone, benzophenone and 4,4'-bisdialkylaminobenzophenones. These compounds can be used alone or as a mixture of two or more. If necessary or desired, conventional photosensitizers such as xanthone derivatives and amines may be added. The amount of the photopolymerization initiator which can be employed in the photosensitive resin composition of the present invention is typically 2 to 8% by weight based on the total weight of the photosensitive resin composition.

Furthermore, in order to prevent the thermal polymerization during its storage, conventional thermal polymerization inhibitors may be employed. Examples of such thermal polymerization inhibitors include hydroquinone, hydroquinone monomethyl ether, pyrogallol, t-butyl catechol and phenothiazine. The amount of the thermal polymerization inhibitor which can be employed in the present invention is typically 0.05 to 0.1% by weight based on the total weight of the photosensitive resin composition.

Exemplary inorganic fillers which can be employed as the fifth essential component (e) of the photosensitive resin composition of the present invention include talc, barium sulfate, barium titanate, titanium oxide, silica, clay, calcium carbonate, alumina and aluminum hydroxide. The amount of the inorganic filler which can be employed in the photosensitive resin composition of the present invention is 10 to 50% by weight based on the total weight of the photosensitive resin composition. When the amount is less than 10% by weight, the adhesion, heat resistance and thermal shock resistance of the cured product are reduced. Amounts of more than 50% by weight also bring about the problems of photosensitivity of the photosensition resin composition and the flexibility of the cured product.

In addition to the above described five essential components, known coloring agents, adhesion promoters, leveling agents, defoaming agents and thixotropic agents can be added to the photosensitive resin composition of the present invention, if necessary or desired.

The photosensitive resin composition of the present invention is coated on printed circuit boards by the conventional method to form a protective coating for soldering, i.e., a solder mask pattern.

In order to form a solder mask pattern, the photosensitive resin composition of the present invention is coated on a printed circuit board where a copper circuit has been formed by the method such as screen printing, roller coating, dip coating, curtain coating and spray coating and then dried at a temperature of from 50°C to 90°C for 5 to 60 minutes. Then, the coated surface of the board is irradiated with ultraviolet rays of 80 to 1000 mJ/cm² through a predetermined negative art work, and a dilute alkaline aqueous solution, e.g., a 1% sodium carbonate aqueous solution is sprayed on to the irradiated surface to effect development. The board thus developed is finally heat-cured at a temperature of from 100°C to 180°C for 10 to 60 minutes to form a solder mask.

With the photosensitive resin composition of the present invention, the viscosity, the concentration and the rheological properties may be adjusted in accordance with the coating method employed by varying the types of the components and their amounts employed. Furthermore, after the development of the solder mask with an aqueous solution or after the heat-curing of the developed solder mask, another irradiation with ultraviolet rays may be conducted to further complete the photocuring.

### INDUSTRIAL APPLICABILITY

The photosensitive resin composition uses, as its base resin, a modified epoxy resin product where in addition to epoxy groups, unsaturated groups and carboxyl groups have been introduced in the molecule and accordingly, it is possible to easily develop the coating after photocuring with an aqueous alkali solution. Thus, there is no problem of environmental pollution by organic solvents and the cost is advantageously reduced. Furthermore, due to the presence of epoxy groups, unsaturated groups and carboxyl groups in the molecule, the modified epoxy resin as such has curability and it is unnecessary to add an epoxy resin for curing in the system and, moreover, the cured products give a protective coating excellent in heat resistance and resistance to gold plating.

In order to further illustrate the present invention, the following examples are provided. However, these examples are not intended to limit the scope of this invention in any way. All parts are by weight unless otherwise stated.

### Preparation 1

### Preparation of Solution of Modified Phenol Novolak Epoxy Resin Product

A phenol novolak epoxy resin (EPPN® -201, a product of Nippon Kayaku Co., Ltd., softening point: 68°C, epoxy equivalent weight: 200) 2000 parts (10 equivalents) was dissolved in a mixture of 941 parts of diethylene glycol monoethyl ether acetate and 404 parts of a solvent naphtha (SOLVESSO® # 150, a product of Exxon). Then 369 parts of acrylic acid were added to the solution and then 24 parts of triphenylphosphine as the reaction catalyst and 2 parts of p-methoxyphenol as the polymerization inhibitor were added thereto. While air was being blown into the resulting mixture, the esterification of epoxy groups in the EPPN® -201 with acrylic acid was carried out at 90°C. Completion of the reaction was determined by titration with an alcoholic potassium hydroxide solution using phenolphthalein as the indicator and the point at which the acid value reached zero was considered as the end point. As a result, the acid value reached zero after 3 hours. Then 21 parts of cumene hydroperoxide having a purity of 80% were added to the reaction mixture solution and the oxidation, i.e., the deactivation of the triphenylphosphine catalyst was carried out at 80°C for 5 hours while air was being blown into the reaction mixture solution.

The reaction product thus obtained was cooled at room temperature and 462 parts of hexahydrophthalic anhydride was added thereto with stirring and was left to stand at 40°C for one week to complete the reaction. The end point of the reaction was determined by the disappearance of an absorption around 1810 cm⁻¹ in the infrared spectrum.

The modified epoxy resin product thus obtained had 68% by weight of solids concentration and contained 45% by mol of the epoxy group, 55% by mol of the acrylic group and 30% by mol of the carboxyl group in one molecule.

### Preparation 2

### Preparation of Solution of Modified Cresol Novolak Epoxy Resin Product

o-Cresol novolak epoxy resin having a softening point of 90°C (YDCN-704, a product of Toto Kasei K.K., epoxy equivalent weight: 215) 2150 parts (10 equivalents) was dissolved in a mixture of 1101 parts of diethylene glycol monoethyl ether and 472 parts of the same SOLVESSO® # 150 as used in Preparation 1. Then 396 parts (5.5 mols) of acrylic acid were added to the solution and 25 parts of triphenylphosphine as the catalyst and 2 parts by hydroquinone as the thermal polymerization inhibitor were added thereto. While air was being blown into the resulting mixture, the esterification of epoxy groups in the cresol novolak epoxy resin with acrylic acid was carried out at 100°C. The amount of the acid in the reaction system, i.e., the acid value reached zero after 2 hours. Then the reaction mixture solution was cooled to 80°C and 22 parts of cumene hydroperoxide having a purity of 80% were added thereto, the oxidation, i.e., deactivation of the triphenylphosphine catalyst was carried out at 80°C for 7 hours while air was being blown into the reaction mixture solution.

To the reaction product thus obtained were added 508 parts (3.3 mols) of hexahydrophthalic anhydride and the reaction was further carried out at 80°C for 5 hours to give a solution of a modified epoxy resin product having a solids concentration of 66% by weight. The mol ratio of the epoxy group : the unsaturated group : the carboxyl group in one molecule of the modified epoxy resin product was 45:55:33.

### Preparation 3

### Preparation of Solution of Modified Cresol Novolak Epoxy Resin Product

In a mixed solvent of 1121 parts of diethylene glycol monoethyl ether acetate and 481 parts of the same SOLVESSO® # 150 as employed in Preparation 1 were dissolved 975 parts (5 equivalents) of a cresol novolak epoxy resin having a softening point of 80°C ("YDCN-702", a product of Toto Kasei K.K., epoxy equivalent weight: 195) and 1000 parts (5 equivalents) of a cresol novolak epoxy resin having a softening point of 85°C ("YDCN-703", a product of Toto Kasei K.K., epoxy equivalent weight: 200). Then, 468 parts (6.5 mols) of acrylic acid were added to the solution and subsequently, 25 parts of triphenylphosphine as the catalyst and 1 part of hydroquinone as the thermal polymerization inhibitor were added thereto. While air was being blown into the resulting mixture, the reaction was carried out at 95°C for 5 hours. It was confirmed by the measurement of the acid value of the reaction mixture solution that hardly any acrylic acid was contained in the reaction mixture solution. Then 18 parts of cumene hydroperoxide having a purity of 80 % were added to the reaction mixture solution and the oxidation/deactivation of the triphenylphosphine catalyst was further carried out at 90°C for 3 hours. Subsequently, 523 parts (3.5 mols) of tetrahydrophthalic anhydride were added to the resulting reaction mixture solution and the reaction was carried out at 90°C for 3 hours. The reaction mixture solution thus obtained was left to stand at 40°C for 3 days to complete the introduction of carboxyl groups. The solids concentration of the modified epoxy resin product thus obtained was 65% by weight and the mol ratio of the epoxy group : the unsaturated group : the carboxyl group in one molecule of the modified epoxy resin product was 35:65:35.

### Preparation 4

### Preparation of Solution of Modified Phenol Novolak Epoxy Resin Product

In a mixed solvent of 1158 parts of diethylene glycol monoethyl ether acetate and 496 of the same SOLVESSO® # 150 as employed in Preparation 1 were dissolved 2000 parts (10 equivalents) of the same EPPN®-201 as in Preparation 1. Then, 504 parts (7.0 mols) of acrylic acid, 31 parts of triphenylphosphine and 3 parts of hydroquinone were added to the resulting solution and the reaction was carried out at 90°C for 6 hours. As a result, the acid value became nearly zero after 6 hours. Then, the reaction mixture solution was cooled to 80°C and 23 parts of cumene hydroperoxide were added thereto and the oxidation/deactivation of the triphenylphosphine catalyst was conducted at 80°C for 7 hours. Then, 532 parts (3.5 mols) of tetrahydrophthalic anhydride were added to the reaction mixture solution and stirred and then, left to stand at 50°C for one week to give a solution of a modified epoxy resin product having a solids concentration of 65% by weight. The mol ratio of the epoxy group : the unsaturated group : the carboxyl group in one molecule of the modified epoxy resin product was 30:70:35.

### Preparation 5

### Preparation of Solution of Modified Phenol Novolak Epoxy Resin Product

In 252.2 parts of ethylene glycol monobutyl ether acetate were dissolved 356 parts (2 equivalents) of a phenol novolak epoxy resin which was a viscous liquid at room temperature, i.e., whose softening point was lower than 60°C (EPIKOTE® 154, a product of Yuka Shell K.K., epoxy equivalent weight: 178). Then 72 parts (1 mol) of acrylic acid, 4.3 parts of triphenylphosphine and 2.1 parts of p-methoxyphenol were added to the resulting solution. While air was being blown into the mixture solution, the reaction was carried out at 100°C for 150 minutes. As a result, the acid value became zero. Subsequently, 1.31 parts of cumene hydroperoxide were added to the reaction mixture solution and the oxidation/ deactivation of the triphenylphosphine catalyst was conducted at 80°C for 7 hours. Then, 154 parts (1 mol) of hexahydrophthalic anhydride were added to the reaction mixture solution and the reaction was carried out at 80°C for 9 hours to give a solution of a modified epoxy resin product having a solids concentration of 70% by weight. The mol ratio of the epoxy group : the unsaturated group : the carboxyl group in one molecule of the modified
epoxy resin product was 50 : 50 : 50.

### Preparation 6

### Preparation of Solution of Modified Phenol Novolak Epoxy Resin Product

In a mixture of 1211 parts of diethylene glycol monoethyl ether acetate and 519 parts of the same SOLVESS® # 150 as used in Example 1, were dissolved 2000 parts (10 equivalents) of the same EPPN® -201 as in Example 1 and then, 750 parts (7 mols) of acrylic acid, 30 parts of tetraethylammonium bromide and 3 parts of hydroquinone were added thereto and the reaction was carried out at 90°C for 12 hours, and the acid value became nearly zero after 12 hours. Then, to the reaction mixture solution were added 462 parts (3 mols) of hexahydrophthalic anhydride and the mixture was stirred at 50°C for one hour to give a solution of a modified epoxy resin product having a solids concentration of 65% by weight. The mol ratio of the epoxy group : the unsaturated group : the carboxyl group in one molecule of the modified epoxy resin product thus obtained was 0 : 100 : 30.

### EXAMPLES

### (Example 1)

A solder resist photosensitive composition was prepared by mixing and kneading the composition in a roll mill as shown below.

| Components of Solder Resist Photosensitive Resin Composition | Parts |
|---|---|
| Solution of modified phenol novolak resin product as obtained in Preparation 1 | 58.0 |
| Dipentaerythritol hexaacrylate (AROMIX® M-400, a product of Toagosei Chemical Industry Co. Ltd.) | 2.0 |
| Melamine fine powder (a product of Nissan Chemical Industries Ltd.) | 1.0 |
| 2-Methyl-1-[4- (methythio)phenyl-2-morpholinopropane-1-on(photopolymerization initiator, IRGACURE® 907, a product of Ciba Geigy) | 4.0 |
| Diethylthioxanthone (KAYACURE® DETX-S, photosensitizer, a product of Nippon Kagaku Co., Ltd.) | 0.4 |
| Barium sulfate (B-34, a product of Sakai Chemical Industry Co., Ltd.) | 30.0 |
| Fine powder silica (AEROSIL® # 380, a product of Nippon Aerosil Co., Ltd.) | 2.0 |
| Cyanin Green (pigment: green, a product of Dainichiseika Color & Chemicals MFG. Co., Ltd.) | 0.6 |
| Pigment yellow (a product of Dainichiseika Color & Chemicals MFG. Co., Ltd.) | 1.0 |
| Defoaming agent (TSA-750S, a product of Toshiba Silicone Co., Ltd.) | 1.0 |

Then, this photosensitive resin composition was screen-printed on a smoothly polished, copper-clad laminate plate by using a 100 mesh screen by the conventional method, dried at 73°C for 25 minutes and cooled to room temperature. The coating of the photosensitive resin composition thus obtained was irradiated with ultraviolet rays of 300 mJ/cm² through a negative mask bearing test patterns and then, developed by spraying a 1% sodium carbonate aqueous solution to the irradiated surface for 30 seconds. The laminate plate thus developed was heat-cured at 150°C for 30 minutes to give a test piece for evaluating solder mask performances.

### (Examples 2 to 5 & Comparative Examples 1 to 3)

Photosensitive resin compositions as shown in Table 1 were prepared in the same manner as in Example 1 and then test pieces for evaluating solder mask performances were prepared in the same manner as in Example 1.

### (Evaluation Methods)

The properties as the solder mask were evaluated by the methods as set forth below.

### Tack

In the same manner as in Example 1, a photosensitive resin composition was coated on a copper-lined laminate plate and dried, and then touched with a finger tip to evaluate the tack of the surface of the coating on the following scale.
- 0 :: Total absence of perceivable tack
- 1 :: Slightly perceivable tack
- 2 :: Conspicuously perceivable tack
- 3 :: Adhesion of resin to finger tip

### Surface Gloss

The surface gloss of the coating of a test piece for evaluating sold mask performances as obtained in the same manner as in Example 1 was observed by the naked eye.

### Sensitivity

A photosensitive resin composition was printed on a copper-clad laminate plate in the same manner as in Example 1 and irradiated with ultraviolet rays of 300 mJ/cm² through a Photec® 21-step tablet (a product of Hitachi Chemical Co., Ltd.) and developed with a 1% sodium carbonate aqueous solution for 30 seconds. The sensitivity was shown by the number of steps remaining after the development.

### Developability

When a solder mask pattern obtained by printing a photosensitive resin composition on a copper-clad laminate plate and irradiating the coating with ultraviolet rays in the same manner as in Example 1, was developed by spraying a 1% sodium carbonate aqueous solution on to the irradiated surface of the coating under a pressure of 2 kg/cm², a minimum time of period capable of developing the coating was recorded as the developability.

### Adhesion

In a test piece for evaluating solder mask performances as obtained in the same manner as in Example 1, cross cuts were made after the pattern of a checkerboard in accordance with the testing method of JIS-D-0202 and then, the test piece was subjected to the peel test with a cellophane tape. The number of cut squares not peeled off with a cellophane tape per 100 cut squares was recorded.

### Pencil Hardness

A test piece for evaluating solder mask performances as obtained in the same manner as in Example 1 was subject to the scratch test by scratching the coating with pencils having various hardnesses in accordance with the testing method of JIS-K-5400. The hardness of the coating was shown by the maximum hardness which inflicted no scratch on the coating.

### Boiling Test

A test piece for evaluating solder mask performances was immersed in boiling water for one hour and then, subjected to the above described adhesion test, and the number of cut squares not peeled off with a cellophane tape per 100 cut squares was recorded.

### Solvent Resistance

A test piece for evaluating solder mask performances was immersed in various solvents at room temperature for 60 minutes and then, the change in the external appearance was observed by the naked eye.

### Chemical Resistance

A test piece for evaluating solder mask performances was immersed in an aqueous solution of a 10% by weight of various chemicals at room temperature for 30 minutes and then, the change in the external appearance was observed by the naked eye.

### Soldering Heat Resistance

A test piece for evaluating solder mask performances was coated with various fluxes and left to float in a solder bath at 260°C for 20 seconds and then cooled. After this procedure was repeated three times, the external appearance was observed by the naked eye.

### Resistance to Electroless Plating

A test piece for evaluating solder mask performances was subjected nickel plating at a pH of 5.0 at 85°C for 10 minutes by preparing a plating bath of ICP Nicoron U (a product of Okuno Chemical Industries Co., Ltd.) as specified by the maker to have nickel deposited thereon in a thickness of 5 mm and then, subjected to gold plating at a pH of 5.8 at 80°C for 20 minutes by preparing a plating bath of OPC Munden Gold (a product of Okuno Chemical Industries Co., Ltd.) as specified by the maker to have gold deposited thereon in a thickness of 0.1 mm. The external appearance of the test piece thus obtained by the plating treatment was observed by the naked eyes.

The results of evaluating solder mask performances of the photosensitive resin compositions of Examples 1 to 5 and Comparative Examples 1 to 3 based on the above described testing methods are shown in Table 2.

From the results as shown in Table 2, it can be understood that by using the photosensitive resin composition of the present invention, solder masks having excellent resistance to chemicals, resistance to soldering heat and resistance to plating can be obtained.

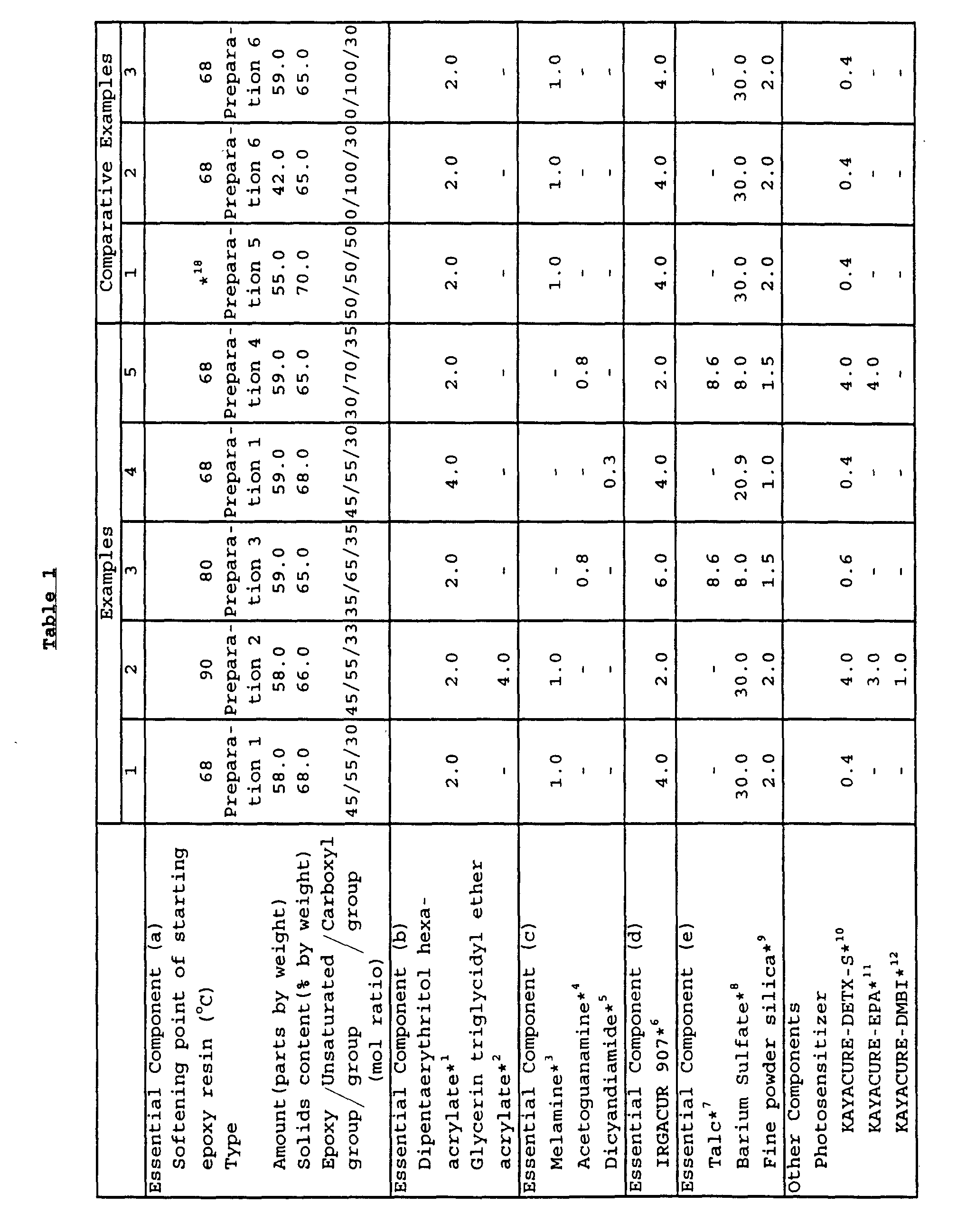

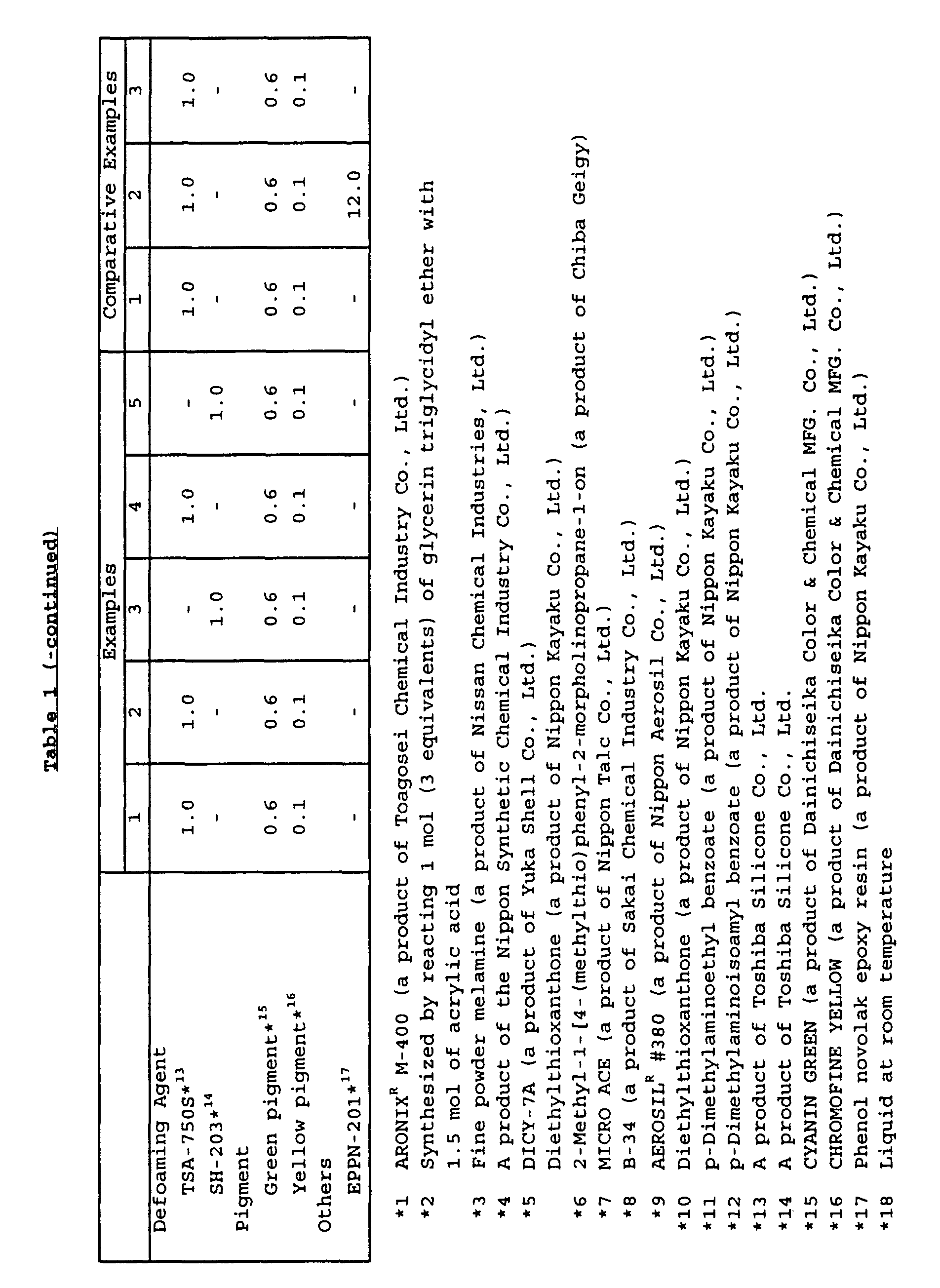

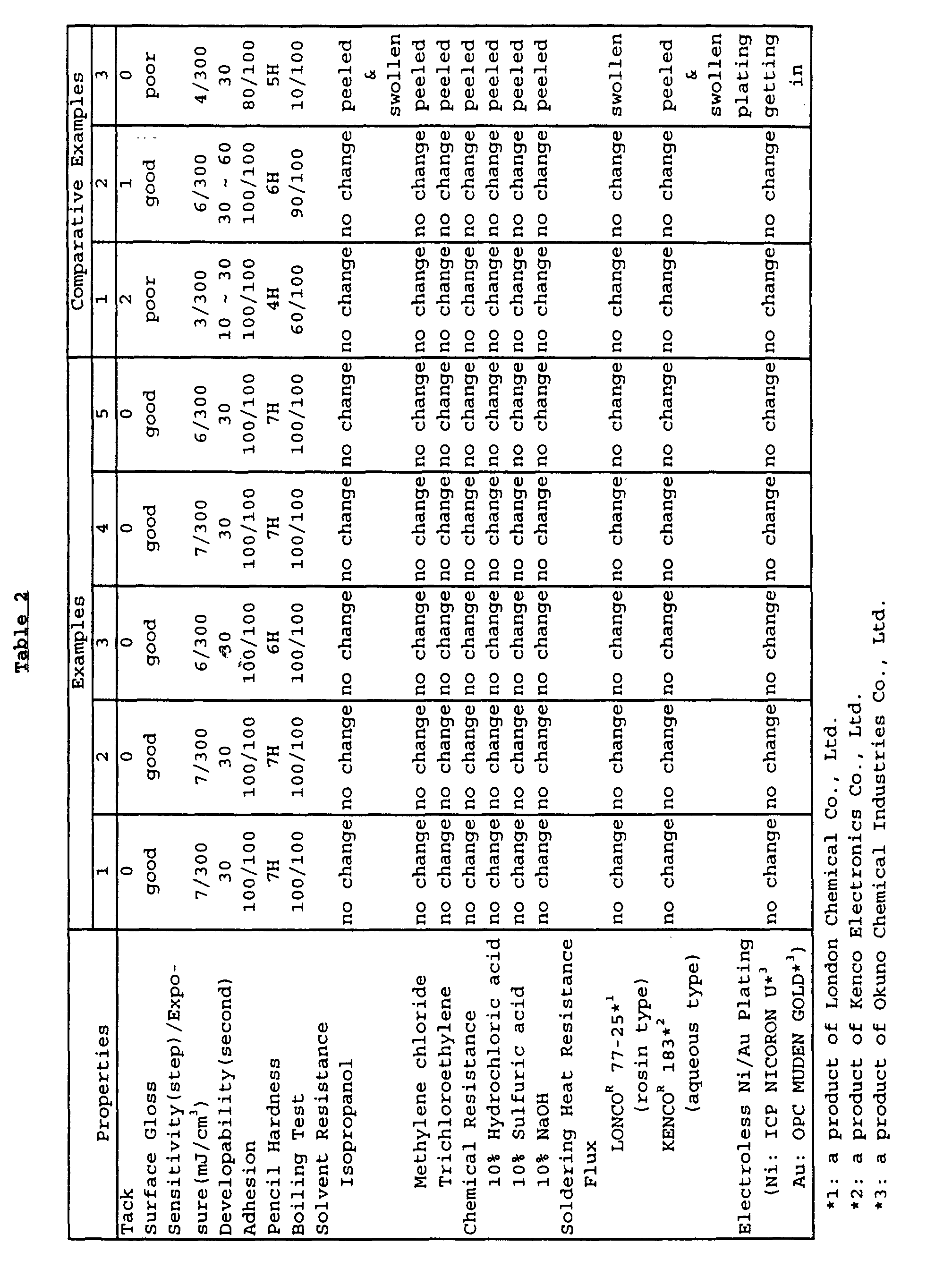

## Claims

1. A modified epoxy resin product having a unit (A) represented by the formula (A), 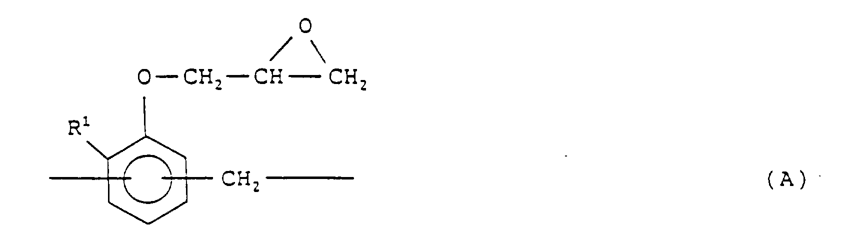 a unit (B) represented by the formula (B), 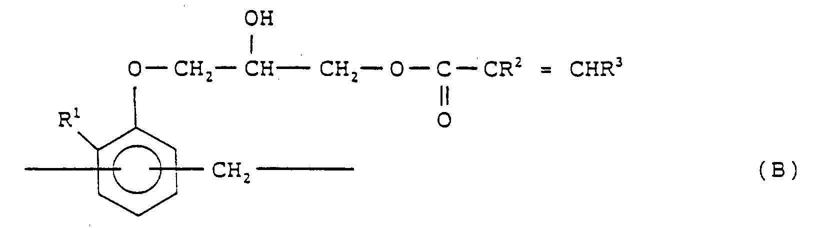 and a unit (C) represented by the formula (C), 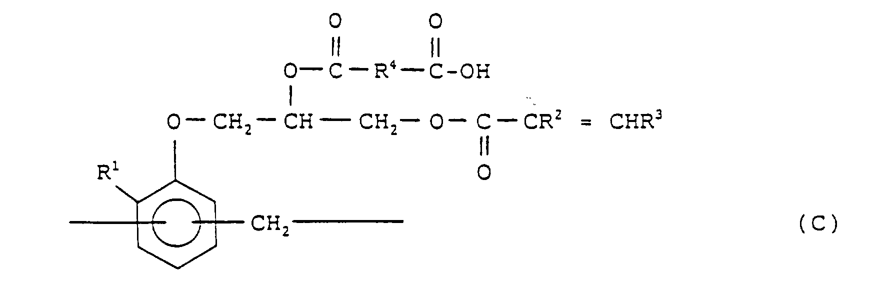 wherein
R¹ is a hydrogen or a methyl group;
R² is a hydrogen or a methyl group;
R³ is a hydrogen, a methyl group or a phenyl group; and
R⁴ is a residue of an aliphatic or aromatic polycarboxylic acid anhydride,
at a mol ratio of the epoxy group : the unsaturated group : the carboxyl group in the molecule being 30-70 : 30-70 : 10-70 and the modified epoxy resin product being obtainable by reacting a novolak epoxy resin having a softening point of not lower than 60°C with an unsaturated monocarboxylic acid represented by the formula (1), 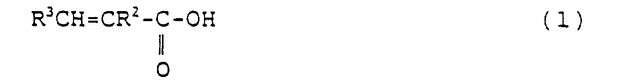 wherein
R² and R³ are the same as defined above, in an amount of 30 to 70% by mol per equivalent of the epoxy group in the starting novolak epoxy resin in the presence of a trivalent organic phosphorus compound as the catalyst in a diluent; deactivating the catalytic action of the trivalent organic phosphorus compound; and subsequently reacting the resulting reaction product with a polycarboxylic acid anhydride represented by the formula (2). 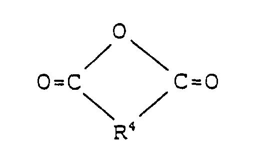 wherein
R⁴ is the same as defined above, in an amount of 10 to 70% by mol per equivalent of the epoxy group in the starting novolak epoxy resin.

2. The modified epoxy resin product of claim 1, wherein R¹ in formulae (A), (B) and (C) is a hydrogen.

3. The modified epoxy resin product of claim 1, wherein R¹ in formulae (A), (B) and (C) is a methyl group.

4. The modified epoxy resin product of claim 1, wherein in R² in formulae (B), (C) and (1) is a hydrogen and R³ in formulae (B), (C) and (1) is a hydrogen.

5. The modified epoxy resin product of claim 1, wherein R4 in formulae (C) and (2) is a residue of hexahydrophthalic anhydride.

6. The modified epoxy resin product of claim 1, wherein R⁴ in formulae (C) and (2) is a residue of tetrahydrophthalic acid.

7. The modified epoxy resin product of claim 1, wherein the trivalent organic phosphorus compound is triphenylphosphine.

8. A photosensitive resin composition which comprises:
(a) 40 to 70 by weight of a solution of a modified epoxy resin product having a solids concentration of 25 to 91% by weight and a unit (A) represented by the formula (A), 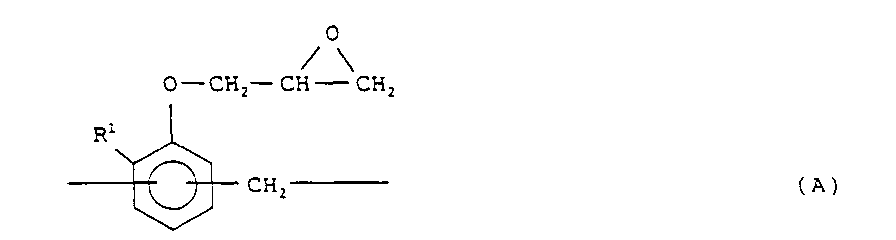 a unit (B) represented by the formula (B), 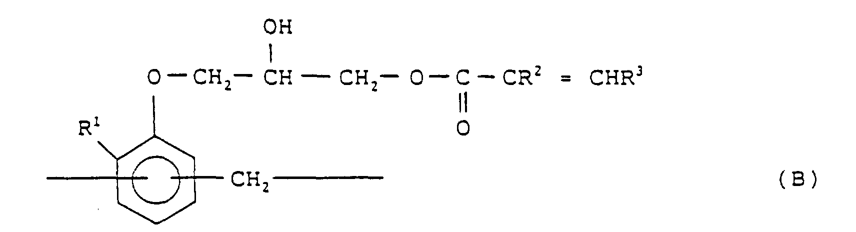 and a unit (C) represented by the formula (C), 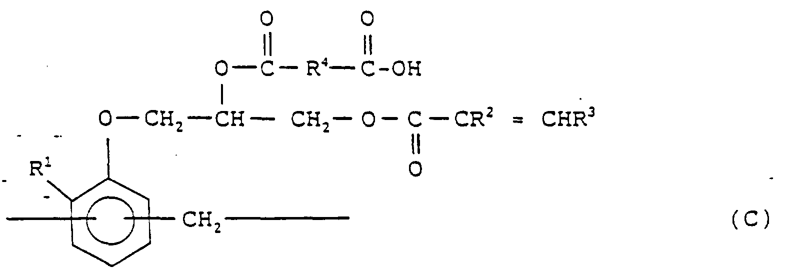 wherein
R¹ is a hydrogen or a methyl group;
R² is a hydrogen or a methyl group;
R³ is a hydrogen, a methyl group or a phenyl group; and
R⁴ is a residue of an aliphatic or aromatic polycarboxylic acid anhydride,
with a mol ratio of the epoxy group in unit (A) : the unsaturated group in unit (B) : the carboxyl group in unit (C) in one molecule being 30-70:30-70:10-70 and the modified epoxy resin being obtained by
reacting a novolak epoxy resin having a softening point of not lower than 60°C and
having a unit (A) represented by the formula (A), 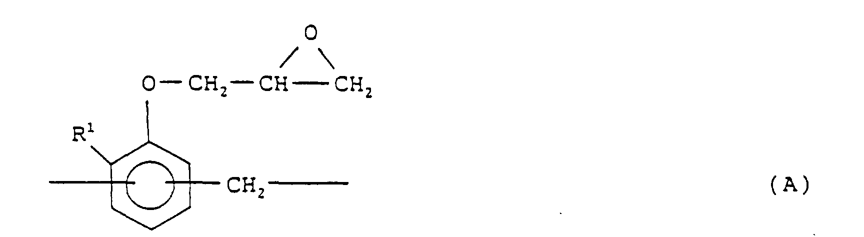
wherein
R¹ is the same as defined above, with an unsaturated monocarboxylic acid represented by the formula (1), 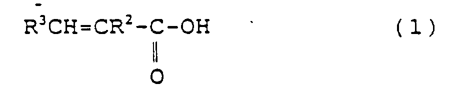 wherein
R² and R³ are the same as defined above,
in an amount of 30 to 70% by mol per equivalent of the epoxy group present in the starting novolak epoxy resin in the presence of a trivalent organic phosphorus compound as the catalyst in a diluent;
deactivating the catalytic action of the trivalent organic phosphorus compound; and subsequently reacting the resulting reaction product with a polycarboxylic acid anhydride represented by the formula (2), 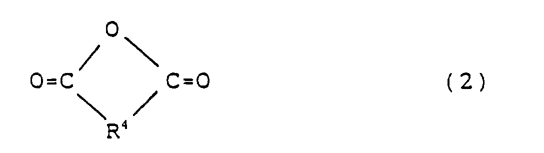 wherein
R⁴ is the same as defined above, in an amount of 10 to 70% by mol per equivalent of the epoxy group present in the starting novolak epoxy resin;
(b) 1 to 10% by weight of an unsaturated compound having at least three unsaturated groups in the molecule;
(c) 0.1 to 2% by weight of an epoxy resin curing agent;
(d) 2 to 15% by weight of a photopolymerization initiator; and
(e) 10 to 50% by weight of an inorganic filler.

9. The photosensitive resin composition of claim 8, wherein R¹ in formulae (A), (B) and (C) is a hydrogen.

10. The photosensitive resin composition of claim 8, wherein R¹ in formulae (A), (B) and (C) is a methyl group.

11. The Photosensitive resin composition of claim 8, wherein R² in formulae (B), (C) and (1) is a hydrogen and R³ in formulae (B), (C) and (1) is a hydrogen.

12. The photosensitive resin composition of claim 8, wherein R⁴ in formulae (C) and (2) is a residue of hexahydrophthalic anhydride.

13. The photosensitive resin composition of claim 8, wherein R4 in formulae (C) and (2) is tetrahydrophthalic anhydride.

14. The photosensitive resin composition of claim 8, wherein the unsaturated compound having at least three unsaturated groups in the molecule is dipentaerythritol hexaacrylate.

15. The photosensitive resin composition of claim 8, wherein the unsaturated compound having at least three unsaturated groups is glycerin triglycidyl ether tetraacrylate.

16. The photosensitive resin composition of claim 8, wherein the epoxy resin curing agent is one member selected from the group consisting of melamines, dicyan diamides, imidazoles, ureas and guanamines.

## Patentansprüche

1. Modifiziertes Epoxyharzprodukt mit einer Einheit (A), dargestellt durch die Formel (A), 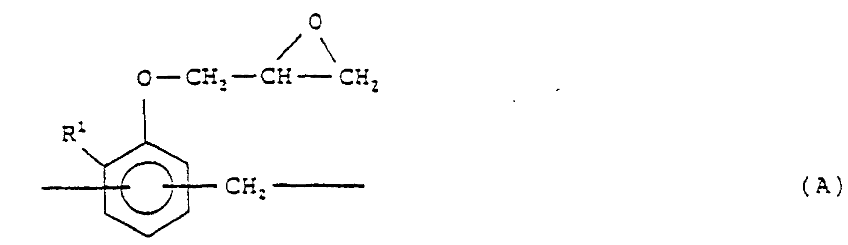 einer Einheit (B), dargestellt durch die Formel (B), 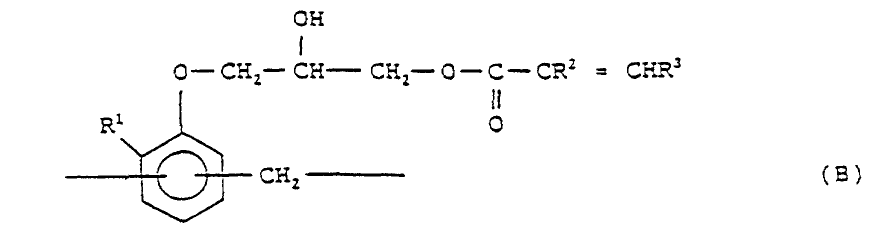 und einer Einheit (C), dargestellt durch die Formel (C), 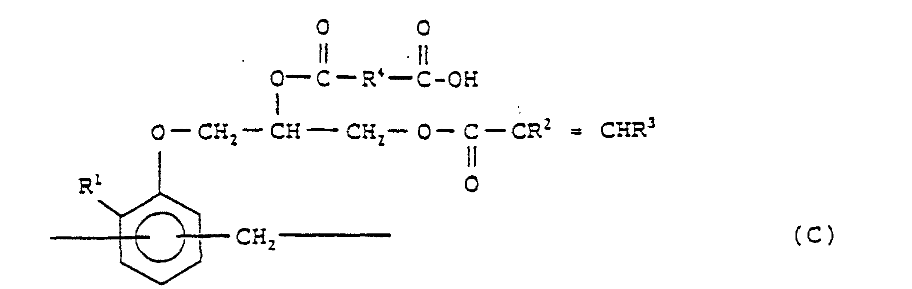 worin
R¹ ein Wasserstoff oder eine Methylgruppe;
R² ein Wasserstoff oder eine Methylgruppe;
R³ ein Wasserstoff, eine Methylgruppe oder eine Phenylgruppe und
R⁴ ein Rest eines aliphatischen oder aromatischen Polycarboxylsäureanhydrids ist,
mit einem Molverhältnis der Epoxygruppe : der ungesättigten Gruppe : der Carboxylgruppe im Molekül von 30 bis 70 : 30 bis 70 : 10 bis 70, wobei das modifizierte Epoxyharzprodukt erhältlich ist durch Umsetzen eines Novolak-Epoxyharzes mit einem Erweichungspunkt von nicht kleiner als 60°C mit einer ungesättigten Monocarbonsäure, dargestellt durch die Formel (1) 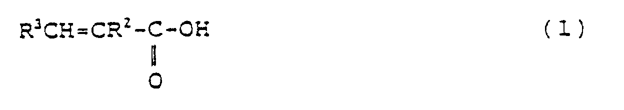 worin
R² und R³ genauso sind wie oben definiert, in einer Menge von 30 bis 70 Mol-% pro Äquivalent der Epoxygruppe im Ausgangsnovolak-Epoxyharz in Gegenwart einer dreiwertigen organischen Phosphorverbindung als Katalysator in einem Verdünnungsmittel; Desaktivieren der katalytischen Wirkung der dreiwertigen organischen Phosphorverbindung und anschließend Umsetzen des resultierenden Umsetzungsprodukts mit einem Polycarbonsäureanhydrid, dargestellt durch die Formel (2) 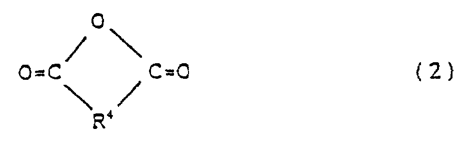 worin
R⁴ genauso ist wie oben definiert,
in einer Menge von 10 bis 70 Mol-% pro Äquivalent der Epoxygruppe im Ausgangsnovolak-Epoxyharz.

2. Modifiziertes Epoxyharzprodukt nach Anspruch 1, worin R¹ in den Formeln (A), (B) und (C) Wasserstoff darstellt.

3. Modifiziertes Epoxyharzprodukt nach Anspruch 1, worin R¹ in den Formeln (A), (B) und (C) eine Methylgruppe darstellt.

4. Modifiziertes Epoxyharzprodukt nach Anspruch 1, worin R² in den Formeln (B), (C) und (1) und R³ in den Formeln (B), (C) und (1) Wasserstoff darstellt.

5. Modifiziertes Epoxyharzprodukt nach Anspruch 1, worin R⁴ in den Formeln (C) und (2) einen Hexahydrophthalsäureanydridrest darstellt.

6. Modifiziertes Epoxyharzprodukt nach Anspruch 1, worin R⁴ in den Formeln (C) und (2) einen Tetrahydrophthalsäurerest darstellt.

7. Modifiziertes Epoxyharzprodukt nach Anspruch 1, worin die dreiwertige organische Phosphorverbindung Triphenylphosphin darstellt.

8. Photosensitive Harzzusammensetzung, die umfasst:
(a) 40 bis 70 Gew.-% einer Lösung eines modifizierten Epoxyharzprodukts mit einer Feststoffkonzentration von 25 bis 91 Gew.-% und einer Einheit (A), dargestellt durch die Formel (A) 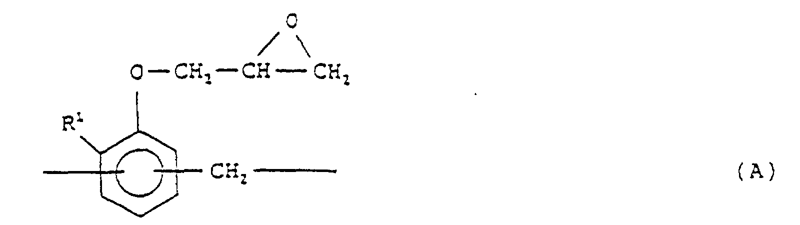 einer Einheit (B), dargestellt durch die Formel (B), 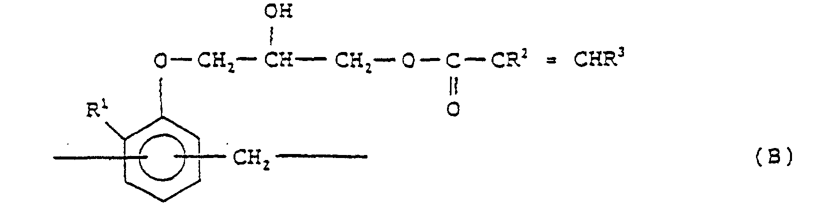 und einer Einheit (C), dargestellt durch die Formel (C), 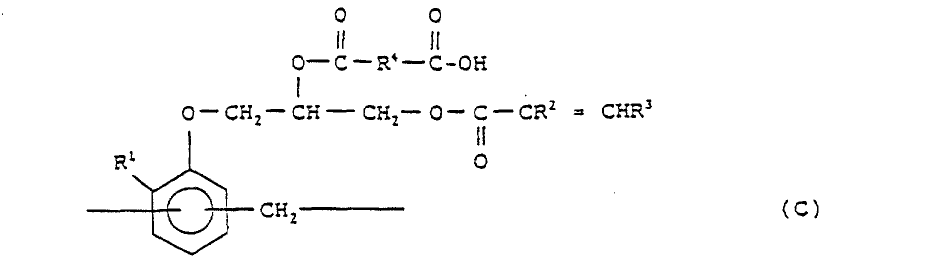 worin
R¹ ein Wasserstoff oder eine Methylgruppe;
R² ein Wasserstoff oder eine Methylgruppe;
R³ ein Wasserstoff, eine Methylgruppe oder eine Phenylgruppe und
R⁴ ein aliphatischer oder aromatischer Polycarbonsäureanhydridrest ist,
mit einem Molverhältnis der Epoxygruppe in Einheit (A) : der ungesättigten Gruppe in Einheit (B) : der Carboxylgruppe in Einheit (C) in einem Molekül von 30 bis 70 : 30 bis 70 : 10 bis 70 und das modifizierte Epoxyharz erhalten wird durch
Umsetzen eines Novolak-Epoxyharzes mit einem Erweichungspunkt nicht kleiner als 60°C und mit einer Einheit (A), dargestellt durch die Formel (A) 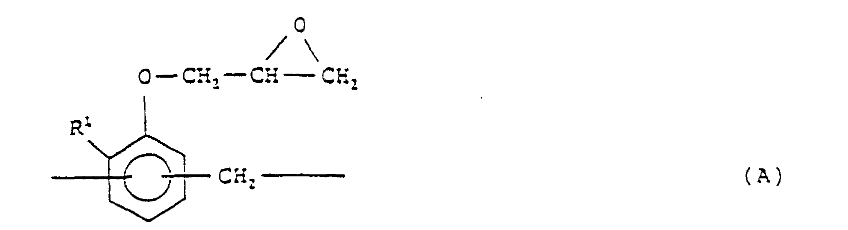 worin
R¹ genauso wie oben definiert ist,
mit einer ungesättigten Monocarbonsäure, dargestellt durch die Formel (1) 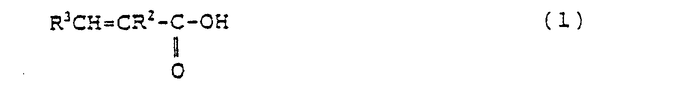 worin
R2 und R3 wie oben definiert sind,
in einer Menge von 30 bis 70 Mol-% pro Äquivalent Epoxygruppe, die in dem Ausgangsnovolak-Epoxyharz vorliegt, in Gegenwart einer dreiwertigen organischen Phosphorverbindung als Katalysator in einem Verdünnungsmittel;
Desaktivieren der katalytischen Wirkung der dreiwertigen organischen Phosphorverbindung und anschließend Umsetzen des resultierenden Reaktionsprodukts mit einem Polycarbonsäureanhydrid, dargestellt durch die Formel (2), 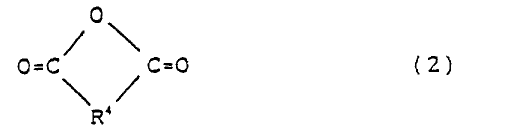 worin
R⁴ genauso wie oben definiert ist,
in einer Menge von 10 bis 70 Mol-% pro Äquivant der in dem Ausgangsnovolak-Epoxyharz vorhandenen Epoxygruppe;
(b) 1 bis 10 Gew.-% einer ungesättigten Verbindung mit mindestens drei ungesättigten Gruppen im Molekül;
(c) 0,1 bis 2 Gew.-% eines Epoxyharz-Härtemittels;
(d) 2 bis 15 Gew.-% eines Photopolymerisationsinitiators und
(e) 10 bis 50 Gew. % eines anorganischen Füllstoffes.

9. Photosensitive Harzzusammensetzung nach Anspruch 8, worin R¹ in den Formeln (A), (B) und (C) Wasserstoff darstellt.

10. Photosensitive Harzzusammensetzung nach Anspruch 8, worin R¹ in den Formeln (A), (B) und (C) eine Methylgruppe darstellt.

11. Photosensitive Harzzusammensetzung nach Anspruch 8, worin R² in den Formeln (B), (C) und (1) und R³ in den Formeln (B), (C) und (1) Wasserstoff darstellt.

12. Photosensitive Harzzusammensetzung nach Anspruch 8, worin R⁴ in den Formeln (C) und (2) einen Hexahydrophthalsäureanhydridrest darstellt.

13. Photosensitive Harzzusammensetzung nach Anspruch 8, worin R⁴ in den Formeln (C) und (2) Tetrahydrophthalsäureanhydrid darstellt.

14. Photosensitive Harzzusammensetzung nach Anspruch 8, worin die ungesättigte Verbindung mit mindestens drei ungesättigten Gruppen im Molekül Dipentaerythritolhexaacrylat darstellt.

15. Photosensitive Harzzusammensetzung nach Anspruch 8, worin die ungesättigte Verbindung mit mindestens drei ungesättigten Gruppen Glycerintriglycidylethertetraacrylat darstellt.

16. Photosensitive Harzzusammensetzung nach Anspruch 8, worin das Epoxyharz-Härtungsmittel ausgewählt ist aus einem Bestandteil aus der aus Melaminen, Dicyandiamiden, Imidazolen, Harnstoffen und Guanaminen gebildeten Gruppe.

## Revendications

1. Produit consistant en une résine époxy modifiée, comprenant un motif (A) représenté par la formule (A) 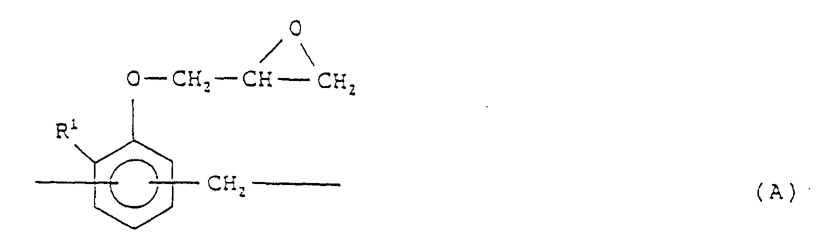 un motif (B) représenté par la formule (B) 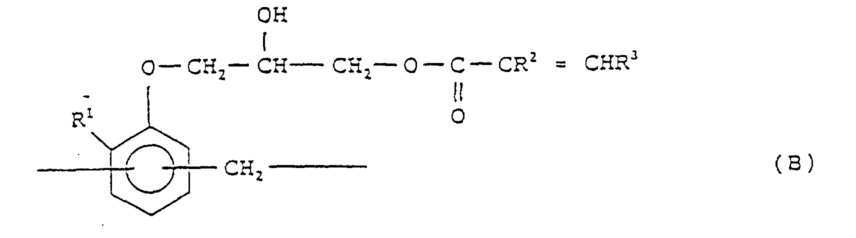 et un motif (C) représenté par la formule (C) 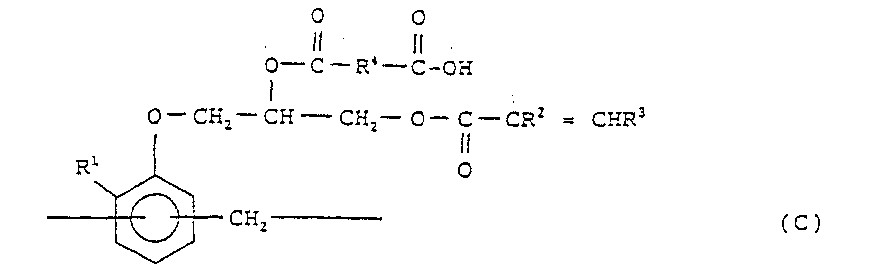 formules dans lesquelles
R¹ représente un atome d'hydrogène ou un groupe méthyle ;
R² représente un atome d'hydrogène ou un groupe méthyle ;
R³ représente un atome d'hydrogène, un groupe méthyle ou un groupe phényle ; et
R⁴ représente un résidu d'un anhydride d'acide polycarboxylique aliphatique ou aromatique,
en un rapport molaire groupe époxy : groupe insaturé : groupe carboxyle dans la molécule compris dans l'intervalle de 30-70 : 30-70 : 10-70, le produit consistant en une résine époxy modifiée pouvant être obtenu en faisant réagir une résine époxy novolaque ayant un point de ramollissement non inférieur à 60°C avec un acide monocarboxylique insaturé représenté par la formule (1) 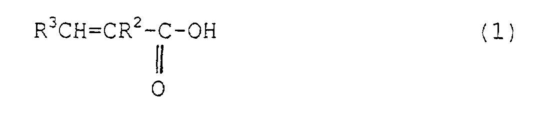 dans laquelle
R² et R³ répondent aux définitions précitées, en une quantité de 30 à 70 % en moles par équivalent du groupe époxy dans la résine époxy novolaque de départ en présence d'un composé organique de phosphore trivalent comme catalyseur dans un diluant ; en désactivant l'action catalytique du composé organique de phosphore trivalent ; et en faisant ensuite réagir le produit de réaction résultant avec un anhydride d'acide polycarboxylique représenté par la formule (2) 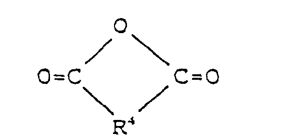 dans laquelle
R⁴ répond à la définition précitée, en une quantité de 10 à 70 % en moles par équivalent du groupe époxy dans la résine époxy novolaque de départ.

2. Produit consistant en une résine époxy modifiée suivant la revendication 1, dans lequel R1 dans les formules (A), (B) et (C) représente un atome d'hydrogène.

3. Produit consistant en une résine époxy modifiée suivant la revendication 1, dans lequel R¹ dans les formules (A), (B) et (C) représente un groupe méthyle.

4. Produit consistant en une résine époxy modifiée suivant la revendication 1, dans lequel R² dans les formules (B), (C) et (1) représente un atome d'hydrogène et R³ dans les formules (B), (C) et (1) représente un atome d'hydrogène.

5. Produit consistant en une résine époxy modifiée suivant la revendication 1, dans lequel R⁴ dans les formules (C) et (2) représente un résidu d'anhydride hexahydrophtalique.

6. Produit consistant en une résine époxy modifiée suivant la revendication 1, dans lequel R⁴ dans les formules (C) et (2) représente un résidu d'acide tétrahydrophtalique.

7. Produit consistant en une résine époxy modifiée suivant la revendication 1, dans lequel le composé organique de phosphore trivalent est la triphénylphosphine.

8. Composition de résine photosensible qui comprend :
(a) 40 à 70 % en poids d'une solution d'un produit consistant en une résine époxy modifiée, ayant une concentration en matières solides de 25 à 91 % en poids et un motif (A) représenté par la formule (A) 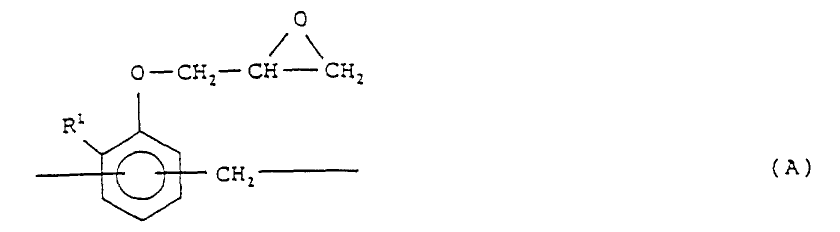 un motif (B) représenté par la formule (B) 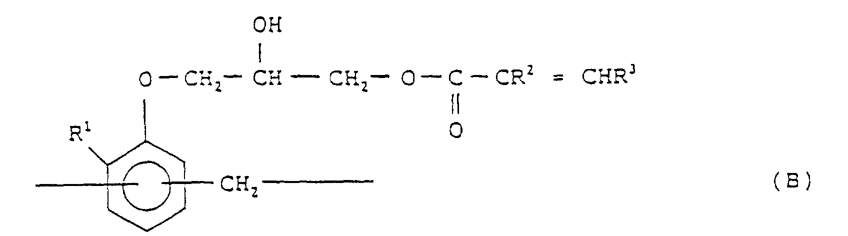 et un motif (C) représenté par la formule (C) 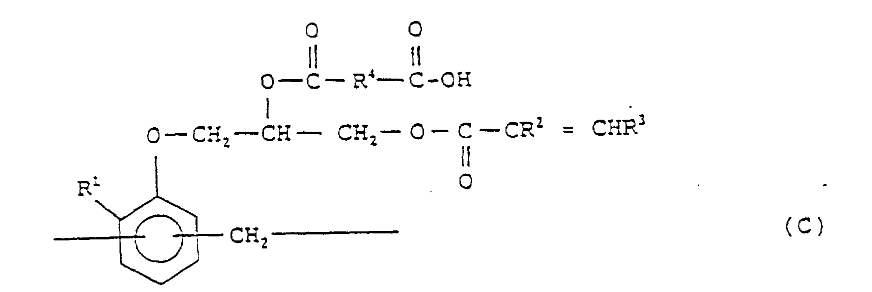 formules dans lesquelles
R¹ représente un atome d'hydrogène ou un groupe méthyle ;
R² xreprésente un atome d'hydrogène ou un groupe méthyle ;
R³ représente un atome d'hydrogène, un groupe méthyle ou un groupe phényle ; et
R⁴ représente un résidu d'un anhydride d'acide polycarboxylique aliphatique ou aromatique,
en un rapport molaire groupe époxy dans le motif (A) : groupe insaturé dans le motif (B) : groupe carboxyle dans le motif (C) dans une molécule compris dans l'intervalle de 30-70 : 30-70 : 10-70, la résine époxy modifiée étant obtenue en faisant réagir une résine époxy novolaque ayant un point de ramollissement non inférieur à 60°C et comprenant un motif (A) représenté par la formule (A) 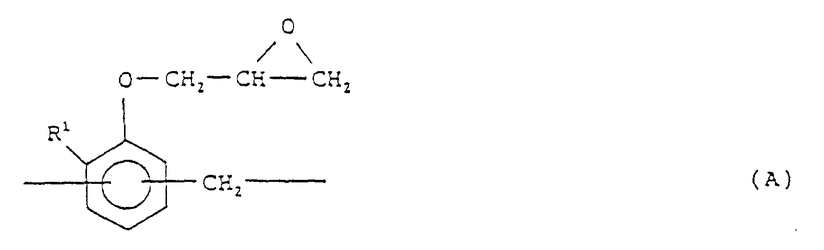 dans laquelle
R¹ répond à la définition précitée, avec un acide monocarboxylique insaturé représenté par la formule (1) 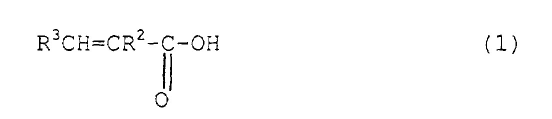 dans laquelle
R² et R³ répondent aux définitions précitées,
en une quantité de 30 à 70 % en moles par équivalent du groupe époxy présent dans la résine époxy novolaque de départ en présence d'un composé organique de phosphore trivalent comme catalyseur dans un diluant ;
en désactivant l'action catalytique du composé organique de phosphore trivalent ; et en faisant ensuite réagir le produit de réaction résultant avec un anhydride d'acide polycarboxylique représenté par la formule (2) 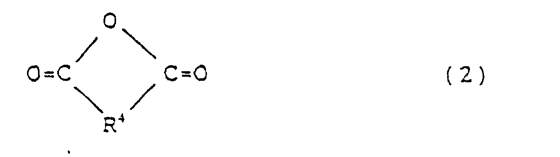
dans laquelle
R⁴ répond à la définition précitée,
en une quantité de 10 à 70 % en moles par équivalent du groupe époxy présent dans la résine époxy novolaque de départ ;
(b) 1 à 10 % en poids d'un composé insaturé ayant au moins trois groupes insaturés dans la molécule ;
(c) 0,1 à 2 % en poids d'un durcisseur de résine époxy ;
(d) 2 à 15 % en poids d'un initiateur de photopolymérisation ; et
(e) 10 à 50 % en poids d'une charge inorganique.

9. Composition de résine photosensible suivant la revendication 8, dans laquelle R¹ dans les formules (A), (B) et (C) représente un atome d'hydrogène.

10. Composition de résine photosensible suivant la revendication 8, dans laquelle R¹ dans les formules (A), (B) et (C) représente un groupe méthyle.

11. Composition de résine photosensible suivant la revendication 8, dans laquelle R² dans les formules (B),
(C) et (1) représente un atome d'hydrogène et R³ dans les formules (B), (C) et (1) représente un atome d'hydrogène.

12. Composition de résine photosensible suivant la revendication 8, dans laquelle R⁴ dans les formules (C) et (2) représente un résidu d'anhydride hexahydrophtalique.

13. Composition de résine photosensible suivant la revendication 8, dans laquelle R⁴ dans les formules (C) et (2) représente l'anhydride tétrahydrophtalique.

14. Composition de résine photosensible suivant la revendication 8, dans laquelle le composé insaturé ayant au moins trois groupes insaturés dans la molécule est l'hexa-acrylate de dipentaérythritol.

15. Composition de résine photosensible suivant la revendication 8, dans laquelle le composé insaturé ayant au moins trois groupes insaturés est le tétra-acrylate d'éther triglycidylique de glycérol.

16. Composition de résine photosensible suivant la revendication 8, dans laquelle le durcisseur de résine époxy est un membre choisi dans le groupe consistant en des mélamines, des dicyandiamides, des imidazoles, des urées et des guanamines.
